(19) Europäisches Patentamt

European Patent Office

Office européen des brevets

(11) **EP 0 657 071 B1**

(12) **EUROPÄISCHE PATENTSCHRIFT**

(45) Veröffentlichungstag und Bekanntmachung des Hinweises auf die Patenterteilung:
**25.10.2000 Patentblatt 2000/43**

(21) Anmeldenummer: **94920866.4**

(22) Anmeldetag: **28.06.1994**

(51) Int. Cl.[7]: **H03H 11/46**, H03H 11/48, H03B 5/12

(86) Internationale Anmeldenummer:
**PCT/DE94/00734**

(87) Internationale Veröffentlichungsnummer:
**WO 95/01671 (12.01.1995 Gazette 1995/03)**

(54) **MONOLITHISCH INTEGRIERBARER, ABSTIMMBARER RESONANZKREIS UND DARAUS GEBILDETE SCHALTUNGSANORDNUNGEN**

MONOLITHICALLY INTEGRATED, TUNABLE RESONANT CIRCUIT AND CIRCUITRY MADE THEREOF

CIRCUIT RESONNANT ACCORDABLE ET INTEGRABLE DE MANIERE MONOLITHIQUE ET CIRCUITERIES REALISEES A L'AIDE DUDIT CIRCUIT

(84) Benannte Vertragsstaaten:
**AT BE CH DE DK ES FR GB GR IE IT LI LU NL PT SE**

(30) Priorität: **29.06.1993 DE 4321565**

(43) Veröffentlichungstag der Anmeldung:
**14.06.1995 Patentblatt 1995/24**

(73) Patentinhaber:
**Maxim Integrated Products Inc.
Sunnyvale, CA 94086 (US)**

(72) Erfinder: **SCHMIDT, Lothar
DE-30890 Barsinghausen (DE)**

(74) Vertreter:
**Eikenberg & Stilkenböhmer
Patentanwälte,
Schackstrasse 1
30175 Hannover (DE)**

(56) Entgegenhaltungen:
**GB-A- 1 120 592          US-A- 4 383 230**

• **A.W.BUCHWALD ET AL: "High-Speed Voltage-controlled oscillator with quadrature outputs ", ELECTRONIC LETTERS, 14.02.91, Band 27, Nr. 4, Seiten 309 - 310**

**Beschreibung**

In der IC-Technik wird angestrebt, möglichst alle Schaltungsbestandteile vollständig monolithisch integrierbar auszubilden, um die Anordnung externer Bestandteile zu vermeiden. Insbesondere im Fall großer Kapazitäten/Induktivitäten stößt dies jedoch auf Schwierigkeiten, so daß häufig Kompromisse oder unvollkommene Lösungen in Kauf genommen werden.

So sind für monolithisch integrierbare LC-Bandpaßfilter Schaltungskonzepte bekannt, bei denen die notwendigen Induktivitäten als planare Spiralinduktivitäten durch Aluminium-Bahnen auf dem Chip realisiert werden. Solche Induktivitäten sind jedoch zum einen nicht elektrisch einstellbar, zum anderen weisen sie aufgrund ihres Serienwiderstandes und durch parasitäre Koppelkapazitäten nur eine geringe Güte auf (N. M. Nguyen, R. G. Meyer: „Si IC-compatible inductors and LC passive filters", IEEE Journal of Solid-State Circuits, Vol. 25, No. 4, August 1990, S. 1028-1031; N. M. Nguyen, R. G. Meyer: „A Si bipolar monolithic RF bandpass amplifier", IEEE Journal of Solid-State Circuits, Vol. 27, No. 1, Januar 1992, S. 123-127).

Mit der Erfindung soll ein vollständig monolithisch integrierbarer, elektrisch einstellbarer Resonanzkreis angegeben werden, der beispielsweise als einstellbares Bandpaßfilter oder als Resonator für einen steuerbaren Oszillator eingesetzt werden kann und der alle Anforderungen einer hochwertigen IC-Technik erfüllt. Dieses Ziel erreicht die Erfindung durch das Grundkonzept gemäß Patentanspruch 1 und die Weiterbildung dieses Grundkonzepts gemäß den Patentansprüchen 2 - 8.

Die Erfindung geht von der Überlegung aus, die notwendigen Induktivitäten durch Transformation von Impedanzen aus dem Basis- in den Emitterstromkreis geeignet beschalteter Bipolartransistoren zu erzeugen, wobei die Frequenzabhängigkeit der Stromverstärkung ausgenutzt wird. Als Vorteil gegenüber dem bekannten Konzept besitzen die auf diese Weise realisierten Induktivitäten zum einen eine höhere Güte, zum anderen lassen sie sich in einem weiten Frequenzbereich elektrisch einstellen. Darüber hinaus sind die geometrischen Abmessungen solcher Induktivitäten kleiner als die der planaren Spiralinduktivitäten.

Die Ausnutzung der Frequenzabhängigkeit der Stromverstärkung der Bipolartransistoren zur Realisierung von Induktivitäten durch Impedanztransformation ermöglicht es, elektrisch abstimmbare Induktivitäten zu realisieren, mittels derer die Mittenfrequenz eines Resonanzkreises eingestellt werden kann. Als zweites wesentliches Merkmal wird die Dämpfung des Resonanzkreises aufgrund der endlichen Güte der so generierten Induktivitäten durch negative Widerstände reduziert, wobei diese negativen Widerstände ebenfalls aufgrund von Impedanztransformationen entstehen. Die gleichzeitig mit der Abstimmung der Induktivitäten erfolgende Veränderung der Filterkapazitäten führt zu einem in einem großen Bereich näherungsweise linearen Zusammenhang zwischen der elektrischen Stellgröße und der Mittenfrequenz des Resonanzkreises.

Der erfindungsgemäße Resonanzkreis läßt sich gemäß Patentanspruch 9 unmittelbar als aktives ein- oder mehrstufiges Bandpaßfilter einsetzen. Mit besonderem Vorteil kann mit dem erfindungsgemäßen Resonanzkreis aber auch gemäß Patentansprüchen 10 - 14 ein vollständig monolithisch integrierbarer, elektrisch einstellbarer Oszillator gebildet werden, wie er für viele Anwendungen, beispielsweise im Telekommunikationsbereich benötigt wird.

Für solche Oszillatoren sind unterschiedliche Konzepte bekannt, die sich in die drei Gruppen Relaxations-, Ring- und LC-Oszillatoren einteilen lassen.

Relaxationsoszillatoren (z.B. M. Soyuer, J. D. Warnock: „Multigigahertz Voltage-Controlled Oscillators in Advanced Silicon Bipolar Technology", IEEE Journal of Solid-State Circuits, Vol. 27, No. 4, April 1992, S. 668-670; J. G. Sneep, C. J. M. Verhoeven: „A New Low-Noise 100-MHz Balanced Relaxation Oscillator", IEEE Journal of Solid-State Circuits, Vol. 25, No. 3, Juni 1990, S. 692-698; A. A. Abidi, R. G. Meyer: „Noise in Relaxation Oscillators", IEEE Journal of Solid-State Circuits, Vol. 18, No. 6, Dezember 1983, S. 794-802), bei denen eine Kapazität über einen einstellbaren Strom abwechselnd aufgeladen und entladen wird, besitzen zwar einen großen Frequenzeinstellbereich, weisen jedoch aufgrund der fehlenden Frequenzselektivität des Amplitudengangs der Ringverstärkung ein großes Phasenrauschen auf, wodurch die Verwendbarkeit solcher Oszillatoren in vielen Anwendungsfällen, beispielsweise im Mobilfunkbereich oder im Bereich der optischen Datenübertragung, stark eingeschränkt wird.

Aus dem gleichen Grund sind Ringoszillatoren, bei denen die Schwingfrequenz über eine Variation der Laufzeit mehrerer zu einem Ring verschalteter Inverterstufen eingestellt wird, für Anwendungen, die einen Oszillator mit hohen Anforderungen an die spektrale Reinheit verlangen, unbrauchbar (A. W. Buchwald, K. W. Martin: „High-Speed Voltage-Controlled Oscillator With Quadrature Outputs", Electronics Letters, Vol. 27, No. 4, 14. Februar 1991, S. 309-310).

Besser in Bezug auf die spektrale Reinheit sind Schaltungskonzepte für integrierbare LC-Oszillatoren (N. M. Nguyen, R. G. Meyer: „A 1.8-GHz Monolithic LC Voltage-Controlled Oscillator", IEEE Journal of Solid-State Circuits, Vol. 27, No. 3, März 1992, S. 444-450) auf der Basis der eingangs erwähnten LC-Bandpaßfilter, bei denen die notwendigen Induktivitäten als planare Spiralinduktivitäten durch Aluminium-Bahnen auf dem Chip realisiert sind. Diese haben jedoch wiederum den Nachteil, daß sie zum einen nicht elektrisch einstellbar sind und zum anderen aufgrund des Serienwiderstandes sowie durch Koppelkapazitäten nur eine geringe Güte besitzen.

Demgegenüber wird gemäß Patentansprüche 10 - 14 ein steuerbarer, vollständig monolithisch integrierbarer Oszillator durch eine Ringschaltung aus zwei identischen LC-Bandpaßfiltern mit elektrisch einstellbaren Mittenfrequenzen realisiert. Der Vorteil dieses Konzeptes gegenüber bekannten Schaltungskonzepten besteht darin, daß die Realisierung von elektrisch einstellbaren Oszillatoren mit geringem Phasenrauschen ohne externe Resonatoren möglich ist. Durch die Zusammenschaltung des Oszillators aus zwei LC-Bandpaßfiltern mit einstellbarer Mittenfrequenz lassen sich an den beiden Bandpaßfilterausgängen zwei Signale abgreifen, die eine frequenzunabhängige Phasendifferenz von $\pi/2$ besitzen, wodurch die Schaltung als Quadraturoszillator verwendet werden kann. Daraus ergeben sich für einige Anwendungen zusätzliche Vorteile. Es kann aber auch genügen, nur eines der beiden Ausgangssignale der beiden Bandpaßfilter auszukoppeln.

Der Patentanspruch 15 betrifft eine besonders zweckmäßige Praktizierung der Erfindung.

Nachfolgend werden Ausführungsbeispiele der Erfindung anhand der Zeichnungen näher erläutert. Dabei stellen dar:

Fig. 1 schematisch das Grundkonzept eines erfindungsgemäßen Resonanzkreises mit einstellbaren Impedanzen,

Fig. 2 ein erstes Beispiel zur Realisierung der einstellbaren Impedanzen in der Schaltung gemäß Fig. 1,

Fig. 3 ein zweites Beispiel zur Realisierung der einstellbaren Impedanzen in der Schaltung gemäß Fig. 1,

Fig. 4 ein Ausführungsbeispiel für ein aktives Bandpaßfilter unter Verwendung der gemäß Fig. 2 realisierten Impedanzen,

Fig. 5 ein Ausführungsbeispiel für ein aktives Bandpaßfilter unter Verwendung der gemäß Fig. 3 realisierten Impedanzen,

Fig. 6 das Blockschaltbild eines mit zwei Bandpaßfiltern gemäß Fig. 2 oder Fig. 3 gebildeten Oszillators mit Quadratur-Ausgängen und

Fig. 7 ein Ausführungsbeispiel einer der in dem Oszillator gemäß Fig. 6 enthaltenen Treiberstufen.

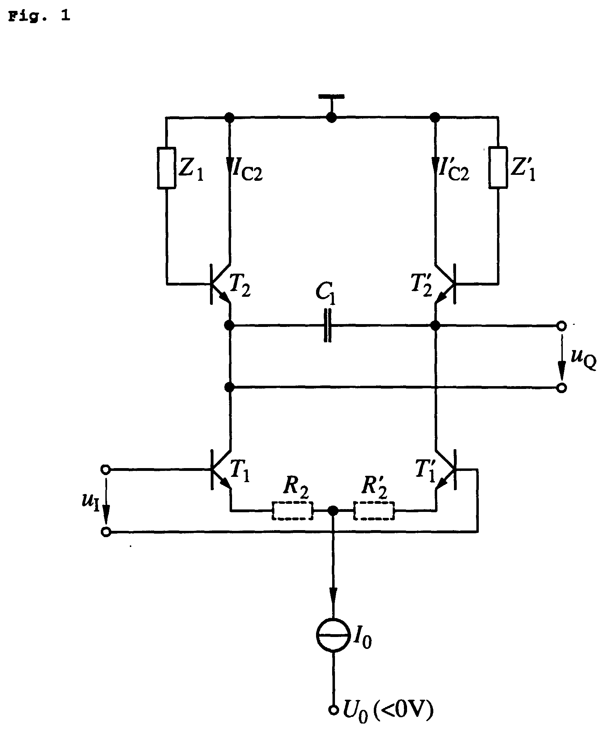

Die Grundstruktur des erfindungsgemäßen Resonanzkreises ist in Fig. 1 dargestellt. Eine aus den beiden Transistoren $T_1$ und $T_1'$ bestehende Differenzverstärkerstufe, die mit dem konstanten Quellenstrom $I_0$ gespeist wird, besitzt an den Kollektoren der genannten Transistoren eine aktive Belastung, die aus den in Kollektorschaltung (Emitterfolger) betriebenen Transistoren $T_2, T_2'$ sowie aus den Impedanzen $Z_1, Z_1'$ besteht. Diese Belastung stellt für Frequenzen oberhalb der 3dB-Grenzfrequenz der Stromverstärkung $\beta$ ($\beta$-Grenzfrequenz) eine Induktivität mit Serienwiderstand dar, sofern die Impedanzen $Z_1, Z_1'$ einen von Null verschiedenen Realteil $Re\{Z_1\}$ bzw. $Re\{Z_1'\}$ aufweisen. Die Stromverstärkung $\beta$ läßt sich für Frequenzen oberhalb der $\beta$-Grenzfrequenz durch den Zusammenhang

$$\beta \cong \frac{\omega_T}{j\omega} \text{ für } \omega > \omega_\beta = \omega_T/\beta_0 \tag{1}$$

annähern, wobei mit $\beta_0$ die Stromverstärkung bei niedrigen Frequenzen, mit $\omega$ die Kreisfrequenz, mit $\omega_\beta$ die 3dB-Grenzkreisfrequenz der Stromverstärkung und mit $\omega_T$ die Transitkreisfrequenz bezeichnet sind. Der Ausgangswiderstand $r_A$ eines in Kollektorschaltung (Emitterfolger) betriebenen Bipolartransistors mit an der Basis angreifender Impedanz $Z_B$ und am Emitter angeschlossener Last $Z_E$ ist gegeben durch

$$r_A \cong \left( \frac{U_T}{I_C} + \frac{Z_B}{\beta} \right) \middle\| Z_E \tag{2}$$

wobei $I_C$ den Kollektorstrom und $U_T$ die Temperaturspannung bezeichnen. Gemäß (1) und (2) lassen sich die Ausgangsimpedanzen $z_{A2}$ und $z_{A2}'$ der Transistoren $T_2$ und $T_2'$ an deren Emitteranschlüssen durch Serienschaltungen aus je einem Widerstand $R_S$ und einer Induktivität $L$ beschreiben, wobei die Ausgangsimpedanzen der Differenzstufen-Transistoren $T_1$ und $T_1'$ vernachlässigt werden ($Z_E \to \infty$, vgl. (2)):

$$z_{A2} = z_{A2}' \cong \frac{U_T}{I_{C2}} + j\omega \, Re\{Z_1\} - \frac{\omega}{\omega_T} Im\{Z_1\} = R_S + j\omega L \tag{3}$$

Die Kollektorströme $I_{C2}$ und $I_{C2}'$ der Transistoren $T_2$ und $T_2'$ betragen im Mittel $0,5 \cdot I_0$ und können für kleine Aussteuerungen als konstant betrachtet werden. Die Güte der Induktivität kann durch geeignete Dimensionierung der

Imaginärteile von $Z_1, Z_1'$ für die Mittenkreisfrequenz $\omega_0$ des Resonanzkreises optimiert werden:

$$\frac{U_T}{I_{C2}} = \frac{U_T}{I'_{C2}} \overset{!}{=} \frac{\omega_0}{\omega_T} \operatorname{Im}\{Z_1\} = \frac{\omega_0}{\omega_T} \operatorname{Im}\{Z_1'\} \quad \Rightarrow \quad R_S = 0 \text{ für } \omega = \omega_0 \qquad (4)$$

Die auf diese Weise erzeugte induktive Last der Differenzstufen-Transistoren kann durch die Einstellung der Realteile von $Z_1, Z_1'$ variiert werden. Die zur Realisierung eines Bandpaßfilters erforderliche Filterkapazität $C_1$ wird differentiell zwischen die Kollektoren der Differenzstufen-Transistoren $T_1, T_1'$ geschaltet.

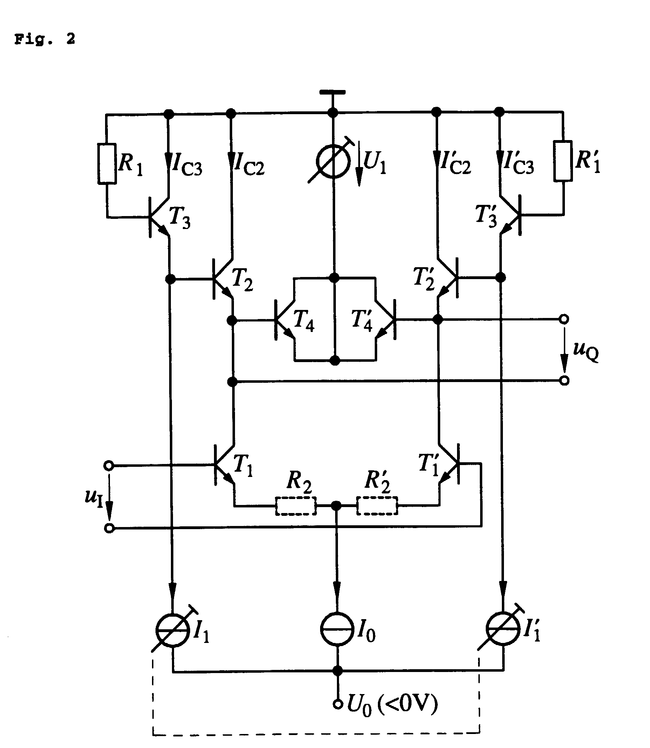

Zur Realisierung der Impedanzen $Z_1, Z_1'$ mit elektrisch einstellbaren Realteilen können, wie in Fig. 2 dargestellt, beispielsweise Emitterfolger $T_3, T_3'$ mit Basisvorwiderständen $R_1, R_1'$ eingesetzt werden. Die Ausgangsimpedanz $z_{A3}$ der Transistoren $T_3$ und $T_3'$ an deren Emittern berechnet sich mit (1) und (2) zu:

$$z_{A3} \cong \frac{U_T}{I_{C3}} + j\omega \frac{R_1}{\omega_T} = \operatorname{Re}\{Z\} + j \operatorname{Im}\{Z\} \qquad (5)$$

wobei die geringe Belastung der Transistoren durch die hohen Eingangsimpedanzen der Transistoren $T_2, T_2'$ und durch die ebenfalls hohen Ausgangsimpedanzen der Stromquellen $I_1, I_1'$ vernachlässigbar ist, d.h. $Z_E \to \infty$ (vgl. (2)) angenommen wird. Die Güte der Induktivität kann gemäß (4) durch geeignete Wahl des Imaginärteils von $Z$, d.h. durch die Dimensionierung von $R_1, R_1'$, für die Mittenkreisfrequenz des Resonanzkreises, d.h. $\omega = \omega_0$, optimiert werden:

$$\frac{U_T}{I_{C2}} = \frac{U_T}{I'_{C2}} \overset{!}{=} \frac{\omega_0^2 \cdot R_1}{\omega_T^2} \quad \Rightarrow \quad R_S = 0 \text{ für } \omega = \omega_0 \qquad (6)$$

Die auf diese Weise erzeugte induktive Last der Differenzstufen-Transistoren $T_1, T_1'$ ist reziprok proportional zum Kollektorstrom der Transistoren $T_3, T_3'$. Die Filterkapazität zwischen den Kollektoren der Differenzstufen-Transistoren $T_1, T_1'$ wird mit den Basis-Kollektor- und den Basis-Emitter-Sperrschichtkapazitäten der Transistoren $T_4, T_4'$ realisiert.

Sowohl die Spannungsabhängigkeit der Filterkapazität als auch die Stromabhängigkeit der induktiven Last werden zur Verstimmung der Mittenfrequenz des Bandpaßfilters verwendet, indem $U_1$ und $I_1, I_1'$ variiert werden. Das Bandpaßausgangssignal $u_Q$ kann an den Kollektoren der Differenzstufen-Transistoren $T_1, T_1'$ abgegriffen werden.

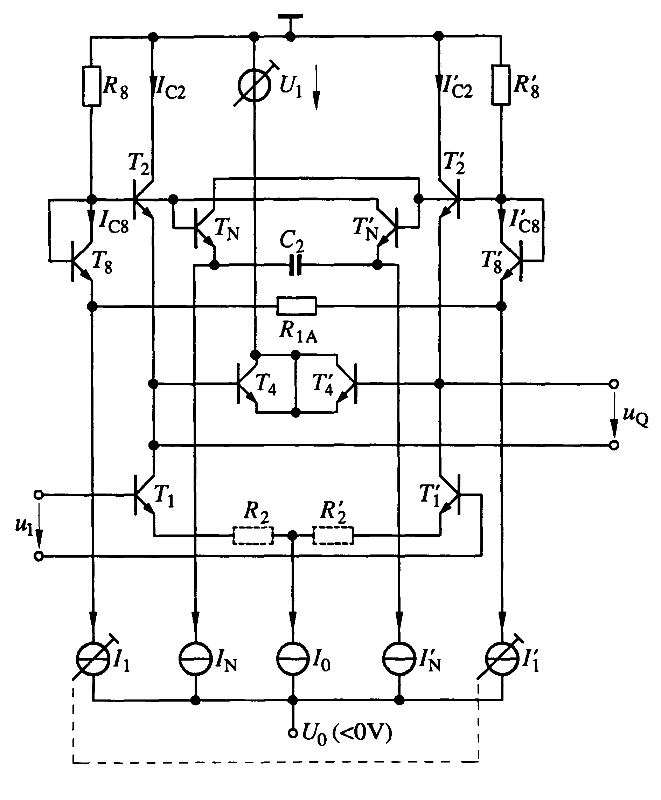

Eine zweite Variante zur Realisierung der Impedanzen $Z_1, Z_1'$ mit elektrisch einstellbaren Realteilen ist in Fig. 3 dargestellt. Diese Variante ist besonders vorteilhaft bei kleinen Betriebsspannungen, wie etwa bei Batteriebetrieb. Die Impedanzen $Z_1, Z_1'$ werden hier durch eine aus den Widerständen $R_8, R_8'$, den als Dioden verschalteten Transistoren $T_8$ und $T_8'$, den einstellbaren Stromquellen $I_1$ und $I_1'$, dem Widerstand $R_{1A}$, den Transistoren $T_N$ und $T_N'$, den Stromquellen $I_N$ und $I_N'$ sowie der Kapazität $C_2$ bestehende Schaltung realisiert. Unter Berücksichtigung von (1) und (2) lassen sich die Impedanzen wie folgt berechnen:

$$Z_1 = Z_1' \cong \left(\left(\frac{U_T}{I_{C8}} + \frac{R_{1A}}{2}\right)\middle\| R_8\right)\middle\| \left(\frac{-\omega_T}{C_2\left(\omega_T^2 + \omega^2\right)} + \frac{-1}{j2\omega C_2}\left(\frac{\omega_T^2 - \omega^2}{\omega_T^2 + \omega^2}\right)\right) \qquad (5)$$

Die auf diese Weise erzeugte induktive Last der Differenz-stufen-Transistoren $T_1, T_1'$ ist abhängig vom Kollektorstrom der Transistoren $T_8, T_8'$. Die Filterkapazität zwischen den Kollektoren der Differenzstufen-Transistoren $T_1, T_1'$ wird wiederum mit den Basis-Kollektor- und den Basis-Emitter-Sperrschichtkapazitäten der Transistoren $T_4, T_4'$

realisiert. Zur Entdämpfung des Bandpaßfilters kann die Kapazität des Kondensators $C_2$ für $\omega = \omega_0$ optimiert werden.

Wie im Beispiel der Fig. 2 werden auch hier sowohl die Spannungsabhängigkeit der Filterkapazität als auch die Stromabhängigkeit der induktiven Last zur Verstimmung der Mittenfrequenz des Bandpaßfilters verwendet, indem $U_1$ und $I_1$, $I_1'$ variiert werden. Das Bandpaßausgangssignal $u_Q$ kann an den Basisanschlüssen der Emitterfolger $T_2, T_2'$ abgegriffen werden.

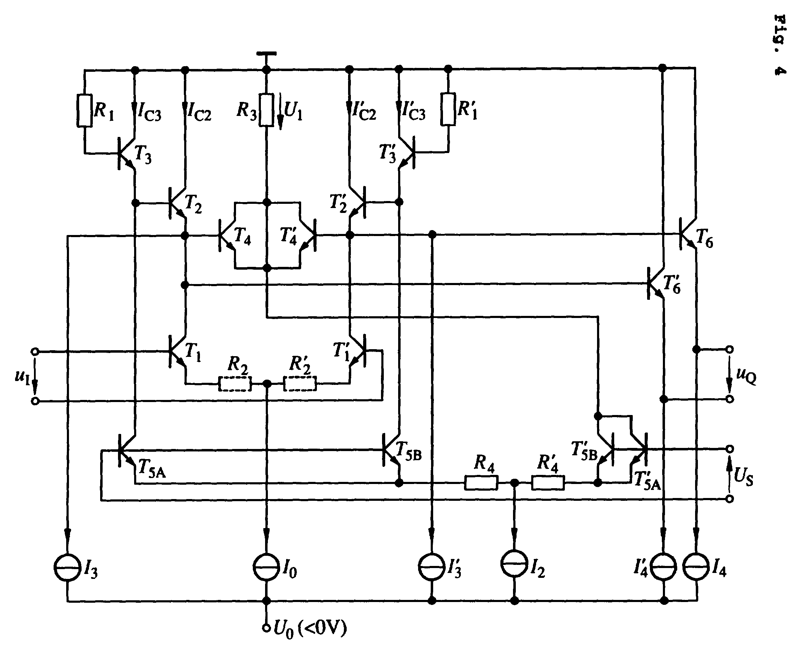

Eine vorteilhafte Ausführung eines auf der gemäß Fig. 2 realisierten Grundstruktur basierenden Bandpaßfilters ist in Fig. 4 dargestellt. Das Bandpaßfilter besteht im Kern aus der in Fig. 2 dargestellten Grundstruktur, wobei die Einstellung der stromabhängigen Induktivitäten und der spannungsabhängigen Kapazitäten in Abhängigkeit von der Stellspannung $U_S$ mittels einer aus den Transistoren $T_{5A}, T_{5B}, T_{5A}', T_{5B}'$ und den Widerständen $R_4, R_4'$ bestehen-den, gegengekoppelten Differenzverstärkerstufe realisiert wird, die von der Konstantstromquelle $I_2$ gespeist wird. Durch die zusätzlichen Konstantströme $I_3, I_3'$ betragen die Kollektorströme $I_{C2}$ und $I_{C2}'$ der Transistoren $T_2$ und $T_2'$ im Mittel $0{,}5 \cdot I_0 + I_3$ bzw. $0{,}5 \cdot I_0 + I_3'$. Mit $I_3 = I_3' >> I_0$ werden die Induktivitäten unabhängig von der Aussteuerung der aus $T_1, T_1'$ und $R_2, R_2'$ bestehenden, gegengekoppelten Differenzverstärkerstufe.

Zur Pegelanpassung und Entkopplung wird das Bandpaßausgangssignal $u_Q$ über die Emitterfolger $T_6, T_6'$, die aus den Konstantstromquellen $I_4, I_4'$ gespeist werden, an den Kollektoren der Differenzstufen-Transistoren $T_1, T_1'$ abgegriffen.

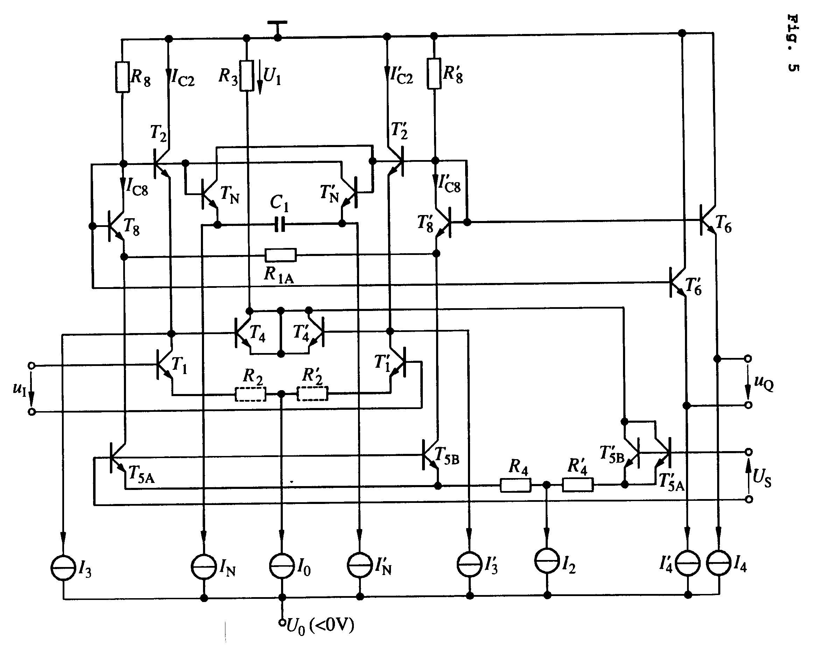

Eine besonders für kleine Betriebsspannungen vorteilhafte Ausführung eines auf der gemäß Fig. 3 realisierten Grundstruktur basierenden Bandpaßfilters ist in Fig. 5 dargestellt. Ebenso wie bei dem Ausführungsbeispiel gemäß Fig. 4 wird hier die Einstellung der stromabhängigen Induktivitäten und der spannungsabhängigen Kapazitäten in Abhängigkeit von der Stellspannung $U_S$ mittels einer aus den Transistoren $T_{5A}, T_{5B}, T_{5A}', T_{5B}'$ und den Widerständen $R_4, R_4'$ bestehenden, gegengekoppelten Differenzverstärkerstufe realisiert, die von der Konstantstromquelle $I_2$ gespeist wird.

Die zusätzlichen Konstantströme $I_3, I_3'$ haben die gleiche Wirkung wie im Ausführungsbeispiel gemäß Fig. 4. Zur Pegelanpassung und Entkopplung wird das Bandpaßausgangssignal $u_Q$ über die Emitterfolger $T_6, T_6'$, die aus den Konstantstromquellen $I_4, I_4'$ gespeist werden, an den Basisanschlüssen der Lasttransistoren $T_2, T_2'$ abgegriffen.

Die Schaltungen gemäß Fig. 4 und Fig. 5 können sowohl als einstufige als auch durch Kaskadierung mehrerer Stufen als mehrstufige, einstellbare Bandpaßfilter eingesetzt werden, wobei die Güte der mehrstufigen Bandpaßfilter zusätzlich erhöht werden kann, indem die Mittenfrequenzen der kaskadierten Filterstufen gegeneinander verstimmt werden (sog. „staggered *tuning*").

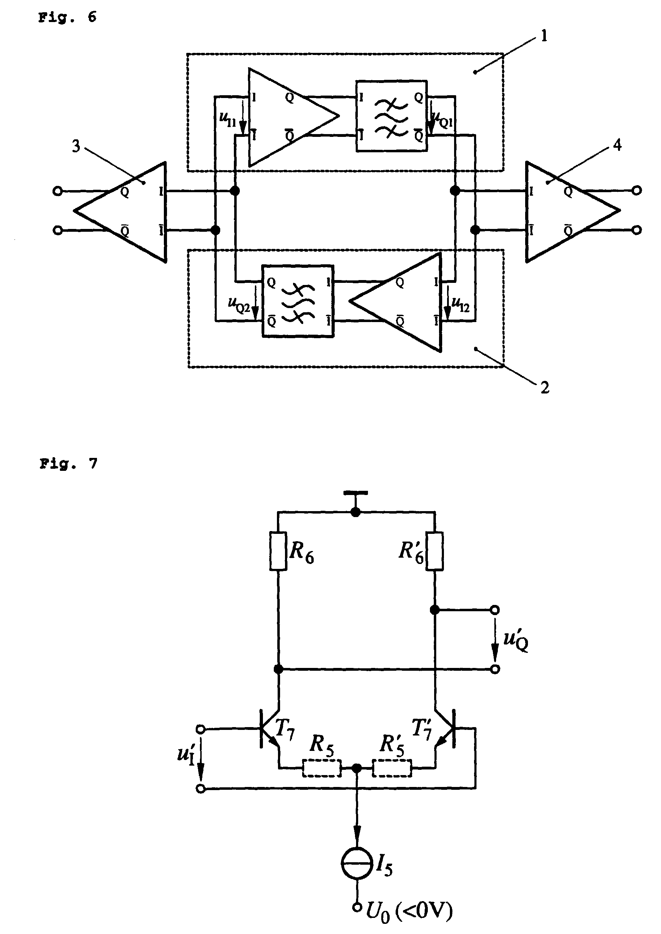

Beim Ausführungsbeispiel in Fig. 6 werden zwei aktive Bandpaßfilter 1, 2 mit Differenzein- und ausgängen derart zu einem Ring verschaltet, daß mit dem Ausgangssignal des aktiven Bandpaßfilters 1 das aktive Bandpaßfilter 2 angesteuert wird, wobei der nicht invertierende Ausgang $Q$ des aktiven Bandpaßfilters 1 den nicht invertierenden Eingang $I$ des aktiven Bandpaßfilters 2 und der invertierende Ausgang $\overline{Q}$ des aktiven Bandpaßfilters 1 den invertierenden Eingang $\overline{I}$ des aktiven Bandpaßfilters 2 ansteuert. Dagegen wird das aktive Bandpaßfilter 1 mit dem Ausgangssignal des Bandpaßfilters 2 invertiert angesteuert, indem der nicht invertierende Ausgang $Q$ des aktiven Bandpaßfilters 2 mit dem invertierenden Eingang $\overline{I}$ des aktiven Bandpaßfilters 1 und der invertierende Ausgang $\overline{Q}$ des aktiven Bandpaßfil-ters 2 mit dem nicht invertierenden Eingang $I$ des aktiven Bandpaßfilters 1 verbunden ist.

Bei der Resonanzfrequenz sind die Bandpaßfilterausgangssignale gegenüber den jeweiligen -eingangssi-gnalen um $-\pi/2$ phasenverschoben. Durch die Invertierung bei der Ansteuerung des aktiven Bandpaßfilters 1 mit dem Ausgangssignal des aktiven Bandpaßfilters 2, die einer zusätzlichen Phasendrehung von $-\pi$ entspricht, wird die Phase in der Ringschaltung insgesamt um $2\pi$ gedreht, d.h. die zur Schwingung erforderliche Mitkopplung wird erreicht. Die darüber hinaus notwendige Amplitudenbedingung wird dadurch erfüllt, daß die Verstärkung der aktiven Bandpaßfilter größer als eins ist.

Gemäß Fig. 6 werden die Ausgangssignale vorteilhafterweise über zwei Ausgangstreiber 3, 4 abgegriffen. Dadurch wird die Belastbarkeit des Oszillators vergrößert und eine Entkopplung von der anzusteuernden Last erreicht. Ein Ausführungsbeispiel für geeignete Treiberstufen ist in Fig. 7 dargestellt. Die Transistoren $T_7, T_7'$ bilden zusammen mit den Gegenkopplungswiderständen $R_5, R_5'$ eine Differenzstufe, die durch die Lastwiderstände $R_6, R_6'$ belastet wird, wobei als ansteuernde Signale der Treiberstufen die Ausgangssignale $u_{Q1}$ und $u_{Q2}$ der Bandpaßfilter verwendet werden. Falls keine Quadraturausgangssignale benötigt werden, ist die Verwendung eines einzelnen Ausgangstreibers, der von einem der beiden Bandpaßfilter angesteuert wird, ausreichend.

## Patentansprüche

1. Monolitisch integrierbarer, abstimmbarer Resonanzkreis, enthaltend eine erste Differenzverstärkerstufe mit zwei Transistoren ($T_1$, $T_1'$), die emitterseitig aus einer Konstantstromquelle ($I_0$) gespeist werden, <u>dadurch gekenn-zeichnet</u>, daß die Transistoren ($T_1$, $T_1'$) an ihren Kollektoren durch ein kollektorseitig mit der Schaltungsmasse ver-bundenes erstes Emitterfolgerpaar ($T_2$, $T_2'$) mit an der Basis angreifenden, elektrisch einstellbaren Impedanzen ($Z_1$, $Z_1'$), die durch Impedanztransformation über das erste Emitterfolgerpaar ($T_2$, $T_2'$) Induktivitäten nachbilden,

induktiv gegenüber der Schaltungsmasse belastet sind, wobei eine spannungsabhängige Kapazität ($C_1$) zwischen den Kollektoren der ersten Differenzstufen-Transistoren ($T_1$, $T_1$') geschaltet ist.

2. Resonanzkreis nach Anspruch 1, <u>dadurch gekennzeichnet</u>, daß die Impedanzen ($Z_1$, $Z_1$') durch Emitterfolger ($T_3$, $T_3$') nachgebildet sind, die mit Basisvorwiderständen ($R_1$, $R_1$') versehen und über Steuerströme ($I_1$, $I_1$') einstellbar sind.

3. Resonanzkreis nach Anspruch 1, <u>dadurch gekennzeichnet</u>, daß die Impedanzen ($Z_1$, $Z_1$') durch zwei als Dioden geschaltete Transistoren ($T_8$, $T_8$') mit zugeordneten Widerständen ($R_8$, $R_8$'), deren Innenwiderstand über Steuerströme ($I_1$, $I_1$') einstellbar ist, sowie durch zwei weitere, kreuzweise geschaltete Transistoren ($T_N$, $T_N$'), die über Steuerströme ($I_N$, $I_N$') einstellbar sind und zwischen den Basen des Emitterfolgerpaares ($T_2$, $T_2$') liegen, nachgebildet sind, wobei die Emitteranschlüsse der zwei als Dioden geschalteten Transistoren ($T_8$, $T_8$') mit einem Widerstand ($R_{1A}$) und die Emitteranschlüsse der kreuzweise geschalteten Transistoren ($T_N$, $T_N$') mit einer Kapazität ($C_2$) verbunden sind.

4. Resonanzkreis nach einem der Ansprüche 1-3, <u>dadurch gekennzeichnet</u>, daß die spannungsabhängige Kapazität ($C_1$) durch zwei Transistoren ($T_4$, $T_4$') gebildet ist, deren jeweils kurzgeschlossene Emitter und Kollektoren verbunden und mit diesem Schaltungsknoten über eine Spannungsquelle ($U_1$) an die Schaltungsmasse gelegt sind.

5. Resonanzkreis nach einem der Ansprüche 1-4, <u>dadurch gekennzeichnet</u>, daß der Linearitätsbereich der Eingangsspannung ($u_T$) der ersten Differenz-verstärkerstufe mit den zwei Transistoren ($T_1$, $T_1$') durch zwei Gegenkopplungswiderstände ($R_2$, $R_2$') vergrößert wird.

6. Resonanzkreis nach einem der Ansprüche 1-5, <u>dadurch gekennzeichnet</u>, daß die Steuerströme ($I_1$, $I_1$') aus einer Konstantstromquelle ($I_2$) mittels einer zweiten Differenzverstärkerstufe mit vier Transistoren ($T_{5A}$, $T_{5B}$, $T_{5A}$', $T_{5B}$') und zwei Gegenkopplungswiderständen ($R_4$, $R_4$') in Abhängigkeit von einer Steuerspannung ($U_S$) erzeugt werden, wobei die Spannungsquelle ($U_1$) durch einen Widerstand ($R_3$) gebildet ist, an dem ein Teil des Quellenstromes ($I_2$) den Spannungsabfall ($U_1$) bewirkt, der zur Steuerung der spannungsabhängigen Kapazitäten ($T_4$, $T_4$') dient.

7. Resonanzkreis nach einem der Ansprüche 1-6, <u>dadurch gekennzeichnet</u>, daß das Ausgangssignal ($u_Q$) differentiell über ein zweites Emitterfolgerpaar aus zwei Transistoren ($T_6$, $T_6$'), die von konstanten Strömen ($I_4$, $I_4$') gespeist werden und die zur Entkopplung und Pegelabsenkung dienen, abgegriffen wird.

8. Resonanzkreis nach einem der Ansprüche 1-7, <u>dadurch gekennzeichnet</u>, daß die ersten Emitterfolger ($T_2$, $T_2$') zusätzlich mit Konstantströmen ($I_3$, $I_3$') gespeist werden.

9. Aktives ein- oder mehrstufiges Bandpaßfilter, bestehend aus einem Resonanzkreis gemäß einem der Ansprüche 1-8 oder mehreren kaskadierten Resonanzkreisen gemäß einem der Ansprüche 1-8.

10. Steuerbarer Oszillator, bestehend aus zwei zu einem Ring verschalteten Resonanzkreisen gemäß Ansprüchen 1-8, wobei das Ausgangssignal ($u_{Q2}$) des zweiten Resonanzkreises invertiert zur Ansteuerung des ersten Resonanzkreises verwendet wird.

11. Oszillator nach Anspruch 10, <u>dadurch gekennzeichnet</u>, daß die Ausgangssignale ($u_{Q1}$ und $u_{Q2}$) der beiden Resonanzkreise (1) und (2) über zwei identische Ausgangstreiberstufen (3) und (4) ausgekoppelt werden, wobei jede dieser beiden Ausgangstreiberstufen eine dritte Differenzverstärkerstufe mit zwei Transistoren ($T_7$, $T_7$') enthält, die differentiell zwischen den Basisanschlüssen mit den Ausgangssignalen ($u_{Q1}$ bzw. $u_{Q2}$) angesteuert wird, wobei die Speisung der Differenzverstärkerstufe durch eine Konstantstromquelle ($I_5$) erfolgt und wobei das Ausgangssignal differentiell zwischen den Lastwiderständen ($R_6$, $R_6$') des Ausgangstreibers oder einphasig, massebezogen an einem dieser Widerstände angegriffen wird.

12. Oszillator nach Anspruch 11, <u>dadurch gekennzeichnet</u>, daß der Linearitätsbereich der Eingangsspannung ($u_1$') der dritten Differenzverstärkerstufe mit den Transistoren ($T_7$, $T_7$') durch zwei Gegenkopplungswiderstände ($R_5$, $R_5$') vergrößert wird.

13. Oszillator nach einem der Ansprüche 10 und 12, <u>dadurch gekennzeichnet</u>, daß die beiden Ausgangssignale ($u_Q$) der Bandpaßfilter bzw. die beiden Ausgangssignale ($u_Q$') der beiden Ausgangstreiberstufen eine frequenzunabhängige Phasendifferenz von $\pi/2$ aufweisen.

**14.** Oszillator nach Anspruch 10 und 12, <u>dadurch gekennzeichnet</u>, daß nur eines der Ausgangssignale ($u_Q$) der beiden Bandpaßfilter ausgekoppelt wird.

**15.** Schaltungsanordnung nach einem der vorhergehenden Ansprüche 1-14, <u>gekennzeichnet durch</u> die Ausführung in ECL-Technik oder E$^2$CL-Technik.

**Claims**

**1.** Monolithically integrated, tunable resonant circuit containing a first differential amplifier stage having two transistors ($T_1$, $T_1$') which are fed on the emitter side from a constant current source ($I_0$), characterized in that the transistors ($T_1$, $T_1$') are loaded inductively with respect to the circuit earth at their collectors by means of a first emitter follower pair ($T_2$, $T_2$'), connected to the circuit earth on the collector side, having electrically adjustable impedances ($Z_1$, $Z_1$') which act on the base and simulate inductances by impedance transformation via the first emitter follower pair ($T_2$, $T_2$'), a voltage-dependent capacitor ($C_1$) being connected between the collectors of the first differential stage transistors ($T_1$, $T_1$').

**2.** Resonant circuit according to Claim 1, characterized in that the impedances ($Z_1$, $Z_1$') are simulated by emitter followers ($T_3$, $T_3$') which are provided with base bias resistors ($R_1$, $R_1$') and can be adjusted via control currents ($I_1$, $I_1$').

**3.** Resonant circuit according to Claim 1, characterized in that the impedances ($Z_1$, $Z_1$') are simulated by two transistors ($T_8$, $T_8$') which are connected as diodes and have assigned resistors ($R_8$, $R_8$') whose internal resistance can be adjusted via control currents ($I_1$, $I_1$'), as well as by two further crosswise connected transistors ($T_N$, $T_N$') which can be adjusted via control currents ($I_N$, $I_N$') and are situated between the bases of the emitter follower pair ($T_2$, $T_2$'), the emitter terminals of the two transistors ($T_8$, $T_8$'), connected as diodes, being connected to a resistor ($R_{1A}$) and the emitter terminals of the crosswise connected transistors ($T_N$, $T_N$') being connected to a capacitor ($C_2$).

**4.** Resonant circuit according to one of Claims 1-3, characterized in that the voltage-dependent capacitance ($C_1$) is formed by two transistors ($T_4$, $T_4$') whose respectively short-circuited emitters and collectors are connected, and are connected by means of this circuit node to the circuit earth via a voltage source ($U_1$).

**5.** Resonant circuit according to one of Claims 1-4, characterized in that the linearity range of the input voltage ($u_I$) of the first differential amplifier stage with the two transistors ($T_1$, $T_1$') is increased by two negative-feedback resistors ($R_2$, $R_2$').

**6.** Resonant circuit according to one of Claims 1-5, characterized in that the control currents ($I_1$, $I_1$') are generated from a constant-current source ($I_2$) by means of a second differential amplifier stage having four transistors ($T_{5A}$, $T_{5B}$, $T_{5A}$', $T_{5B}$') and two negative-feedback resistors ($R_4$, $R_4$') as a function of a control voltage ($U_S$), the voltage source ($U_1$) being formed by a resistor ($R_3$) at which a portion of the source current ($I_2$) effects the voltage drop ($U_1$) which serves to control the voltage-dependent capacitances ($T_4$, $T_4$').

**7.** Resonant circuit according to one of Claims 1-6, characterized in that the output signal ($u_Q$) is tapped differentially via a second emitter follower pair composed of two transistors ($T_6$, $T_6$') which are fed by constant currents ($I_4$, $I_4$') and which serve the purpose of decoupling and level reduction.

**8.** Resonant circuit according to one of Claims 1-7, characterized in that the first emitter followers ($T_2$, $T_2$') are additionally fed with constant currents ($I_3$, $I_3$').

**9.** Active single- or multistage bandpass filter, consisting of a resonant circuit in accordance with one of Claims 1-8 or a plurality of cascaded resonant circuits in accordance with one of Claims 1-8.

**10.** Controllable oscillator consisting of two resonant circuits, connected to form a ring, in accordance with Claims 1-8, the output signal ($u_{Q2}$) of the second resonant circuit being used in an inverted fashion to drive the first resonant circuit.

**11.** Oscillator according to Claim 10, characterized in that the output signals ($u_{Q1}$ and $u_{Q2}$) of the two resonant circuits (1) and (2) are decoupled by two identical output driver stages (3) and (4), each of these two output driver stages including a third differential amplifier stage having two transistors ($T_7$, $T_7$') which is driven in a differential fashion between the base terminals by means of the output signals ($u_{Q1}$ and $u_{Q2}$), the differential amplifier stage being fed by a constant current source ($I_5$) and the output signal being tapped in a differential fashion between the load resistors ($R_6$, $R_6$') of the output driver, or in a single-phase fashion, related to earth, on one of these resistors.

**12.** Oscillator according to Claim 11, characterized in that the linearity range of the input voltage ($u_I$') of the third differential amplifier stage having the transistors ($T_7$, $T_7$') is increased by two negative-feedback resistors ($R_5$, $R_5$').

**13.** Oscillator according to one of Claims 10 and 12, characterized in that the two output signals ($u_Q$) of the bandpass filters or the two output signals ($u_Q$') of the two output driver stages have a frequency-independent phase difference of $\pi/2$.

**14.** Oscillator according to Claims 10 and 12, characterized in that only one of the output signals ($u_Q$) of the two bandpass filters is output.

**15.** Circuit arrangement according to one of the preceding Claims 1-14, characterized by embodiment using ECL technology or E$^2$CL technology.

**Revendications**

**1.** Circuit résonnant accordable et intégrable de manière monolitique comprenant un premier étage d'amplificateur différenciateur avec deux transistors ($T_1$, $T_1$') qui sont alimentés côté émetteur à partir d'une source de courant constant ($I_0$), <u>caractérisé en ce</u> que les transistors ($T_1$, $T_1$') sont aux charges inductives par rapport à la masse du circuit à leurs collecteurs par une première paire d'émetteurs-suiveurs ($T_2$, $T_2$') reliée à la masse du circuit avec des impédances ($Z_1$, $Z_1$') attaquant à la base, pouvant être ajustées électriquement, qui imitent des inductances par transformation d'impédance par la première paire d'émetteurs-suiveurs ($T_2$, $T_2$'), un condensateur ($C_1$) dépendant de la tension étant monté entre les collecteurs des premiers transistors de l'étage différenciateur ($T_1$, $T_1$').

**2.** Circuit résonnant selon la revendication 1, <u>caractérisé en ce</u> que les impédances ($Z_1$, $Z_1$') sont imitées par des émetteurs-suiveurs ($T_3$, $T_3$') qui sont pourvus de résistances série de base ($R_1$, $R_1$') et qui peuvent être ajustés par des courants de commande ($I_1$, $I_1$').

**3.** Circuit résonnant selon la revendication 1, <u>caractérisé en ce</u> que les impédances ($Z_1$, $Z_1$') sont imitées par deux transistors ($T_8$, $T_8$') montés comme diodes avec des résistances correspondantes ($R_8$, $R_8$'), dont la résistance interne peut être ajustée par des courants de commande ($I_1$, $I_1$'), ainsi que par deux autres transistors ($T_N$, $T_N$') montés en croix, qui peuvent être ajustés par des courants de commande ($I_N$, $I_N$') et qui se situent entre les bases de la paire d'émetteurs-suiveurs ($T_2$, $T_2$'), les connexions des émetteurs des deux transistors montés comme diodes ($T_8$, $T_8$') étant reliées à une résistance ($R_{1A}$) et les connexions des émetteurs des transistors montés en croix ($T_N$, $T_N$') étant reliées à un condensateur ($C_2$).

**4.** Circuit résonnant selon l'une des revendications 1 à 3, <u>caractérisé en ce</u> que le condensateur dépendant de la tension ($C_1$) est formé par deux transistors ($T_4$, $T_4$') dont les émetteurs respectivement court-circuités et les collecteurs sont reliés et qui sont mis sur la masse du circuit avec ce noeud de circuit par une source de tension ($U_1$).

**5.** Circuit résonnant selon l'une des revendications 1 à 4, <u>caractérisé en ce</u> que la plage de linéarité de la tension d'entrée ($U_1$) du premier étage amplificateur différenciateur avec les deux transistors ($T_1$, $T_1$') est agrandie par deux résistances de contre-couplage ($R_2$, $R_2$').

**6.** Circuit résonnant selon l'une des revendications 1 à 5, <u>caractérisé en ce</u> que les courants de commande ($I_1$, $I_1$') sont générés à partir d'une source de courant constant ($I_2$) au moyen d'un second étage amplificateur différenciateur avec quatre transistors ($T_{5A}$, $T_{5B}$, $T_{5A}$', $T_{5B}$') et deux résistances de contre-couplage ($R_4$, $R_4$') en fonction d'une tension de commande ($U_S$), la source de tension ($U_1$) étant formée par une résistance ($R_3$) sur laquelle une partie du courant de source ($I_2$) provoque la chute de tension qui sert à la commande des condensateurs dépendant de la tension ($T_4$, $T_4$').

**7.** Circuit résonnant selon l'une des revendications 1 à 6, <u>caractérisé en ce</u> que le signal de sortie ($U_Q$) est pris de manière différentielle par une seconde paire d'émetteurs-suiveurs constituée par deux transistors ($T_6$, $T_6$') qui sont alimentés par des courants constants ($I_4$, $I_4$') et qui servent au découplage et à la baisse du niveau.

**8.** Circuit résonnant selon l'une des revendications 1 à 7, <u>caractérisé en ce</u> que les premiers émetteurs-suiveurs ($T_2$, $T_2'$) sont alimentés en plus avec des courants constants ($I_3$, $I_3'$).

**9.** Filtre passe-bande actif à un ou à plusieurs étages, constitué par un circuit résonnant selon l'une des revendications 1 à 8 ou par plusieurs circuits résonnants en cascade selon l'une des revendications 1 à 8.

**10.** Oscillateur pouvant être commandé, constitué par deux circuits résonnants montés en anneau selon les revendications 1 à 8, le signal de sortie ($U_{Q2}$) du second circuit résonnant étant utilisé inverti pour l'excitation du premier circuit résonnant.

**11.** Oscillateur selon la revendication 10, <u>caractérisé en ce</u> que les signaux de sortie ($U_{Q1}$ et $U_{Q2}$) des deux circuits résonnants (1) et (2) étant découplés par deux étages d'attaque de sortie identiques (3) et (4), chacun de ces deux étages d'attaque de sortie contenant un troisième étage amplificateur différenciateur avec deux transistors ($T_7$, $T_7'$) qui est excité de manière différentielle entre les bornes de base avec les signaux de sortie ($U_{Q1}$ ou $U_{Q2}$), l'alimentation de l'étage amplificateur différenciateur étant effectuée par une source de courant constant ($I_5$) et le signal de sortie étant pris de manière différentielle entre les résistances de charge ($R_6$, $R_6'$) de l'étage excitateur de sortie ou en monophasé par rapport à la masse sur l'une de ces résistances.

**12.** Oscillateur selon la revendication 11, <u>caractérisé en ce</u> que la plage de linéarité de la tension d'entrée ($U_1'$) du troisième étage amplificateur différenciateur avec les transistors ($T_7$, $T_7'$) est agrandie par deux résistances de contre-couplage ($R_5$, $R_5'$).

**13.** Oscillateur selon l'une des revendications 10 et 12, <u>caractérisé en ce</u> que les deux signaux de sortie ($U_Q$) des filtres passe-bande ou les deux signaux de sortie ($U_Q'$) des deux étages d'attaque de sortie présentent une différence de phase indépendante de la fréquence de $\pi/2$.

**14.** Oscillateur selon la revendication 10 et 12, <u>caractérisé en ce</u> que seulement l'un des signaux de sortie ($U_Q$) des deux filtres passe-bande est découplé.

**15.** Dispositif de circuit selon l'une des revendications précédentes 1 à 14, <u>caractérisé par</u> la réalisation en technique de logique ECL ou en technique de logique $E^2CL$.

Fig. 1

Fig. 2

Fig. 4

Fig. 5

Fig. 6

Fig. 7